# EUROPÄISCHE PATENTSCHRIFT

(11) **EP 3 631 381 B1**
(45) Veröffentlichungstag und Bekanntmachung des Hinweises auf die Patenterteilung: **09.08.2023**
(21) Anmeldenummer: 18717033.7
(22) Anmeldetag: 10.04.2018
(51) Int. Cl.: G01F 23/24, G01F 23/26

(54) **VERFAHREN ZUR PROZESSÜBERWACHUNG**
METHOD OF PROCESS MONITORING
PROCÉDÉ DE SURVEILLANCE DE PROCESSUS

(30) Priorität: 24.05.2017 DE 102017111393
(43) Veröffentlichungstag der Anmeldung: 08.04.2020
(73) Patentinhaber: Endress+Hauser SE+Co. KG, 79689 Maulburg (DE)
(72) Erfinder: WERNET, Armin, 79618 Rheinfelden (DE); UPPENKAMP, Kaj, 79664 Wehr (DE); FALGER, Florian, 79685 Häg-Ehrsberg (DE)
(74) Vertreter: Koslowski, Christine Adelheid
(86) Internationale Anmeldenummer: PCT/EP2018/059126
(87) Internationale Veröffentlichungsnummer: WO 2018/215129

(56) Entgegenhaltungen:
- EP-A1- 3 115 757
- EP-A2- 1 882 914
- EP-A2- 1 882 914
- WO-A1-2011/136729
- WO-A1-2014/131639
- WO-A2-2014/145971
- DE-A1-102008 043 412
- DE-A1-102009 030 674
- DE-A1-102013 111 188

## Beschreibung

Die Erfindung betrifft ein Verfahren zur Prozessüberwachung im Sinne einer Überwachung einer Durchmischung zweier Medien in der Automatisierungstechnik anhand einer kapazitiven und konduktiven Messsonde sowie eine entsprechende Vorrichtung.

Mittels einer kapazitiven und/oder konduktiven Messsonde wird in der Automatisierungstechnik in vielen Fällen ein Füllstand überwacht. Bei Einsatz des wohlbekannten, konduktiven Messverfahrens wird zu diesem Zwecke beispielsweise überwacht, ob über das leitfähige Medium ein elektrischer Kontakt zwischen einer Sondenelektrode und der Wandung eines leitfähigen Behälters oder einer zweiten Elektrode besteht. Entsprechende Feldgeräte werden von der Anmelderin beispielsweise unter der Bezeichnung Liquipoint vertrieben.

Bei Medien mit geringer elektrischer Leitfähigkeit (< 1 µS/cm), beispielsweise destilliertem Wasser, Melasse oder Alkoholen, oder auch im Falle von Medien mit einer elektrischen Leitfähigkeit kleiner 1µS/cm und einer Dielektrizitätskonstanten kleiner 20, beispielsweise Ölen und Fetten, ist allerdings eine Änderung der Leitfähigkeit des Mediums im Verhältnis zur Leitfähigkeit von Luft zu gering, um noch sicher von der jeweiligen Elektronik eines typischen konduktiven Füllstandsmessgeräts erfasst werden zu können. In diesen Fällen kommt üblicherweise das ebenfalls bestens bekannte kapazitive Messverfahren zum Einsatz, bei welchem der Füllstand des Mediums aus der Kapazität des von einer Sondenelektrode und der Wandung des Behälters oder einer zweiten Elektrode gebildeten Kondensators ermittelt wird. Je nach Leitfähigkeit des Mediums bildet hierbei entweder das Medium selbst oder eine Sondenisolierung das Dielektrikum des Kondensators. Auch auf dem kapazitiven Messprinzip beruhende Feldgeräte werden von der Anmelderin in vielen unterschiedlichen Ausgestaltungen vertrieben, beispielsweise unter der Bezeichnung Liquicap oder Solicap.

Die Füllstandsdetektion mittels eines kapazitiven Messverfahrens ist zwar prinzipiell für leitfähige und nicht leitfähige Medien möglich, jedoch wird für Medien mit zunehmender Leitfähigkeit vorzugsweise eine Isolation der Messsonde notwendig, da das Medium sonst einen Kurzschluss des Messkreises bewirkt. Die Impedanz dieser Isolierung, insbesondere die der nachfolgend beschriebenen Guardelektrode, ist jedoch für anhaftende Medien nachteilig, da sie eine zusätzlich in Reihe geschaltete Impedanz zum Medium darstellt.

Zur Vermeidung von Ansatzbildung ist aus der DE 32 12 434 C2 die Verwendung eine Guardelektrode bekannt geworden, welche die Sensorelektrode koaxial umgibt und auf dem gleichen elektrischen Potential wie diese liegt. Je nach Beschaffenheit des Ansatzes zeigt sich bei dieser Ausgestaltung das Problem, das Guardsignal passend zu erzeugen. Erweiternd wird in der DE 10 2006 047 780 A1 eine Messsonde mit einer Verstärkungseinheit und einem Begrenzungselement beschrieben, die über einen großen Messbereich hinweg unempfindlich gegenüber Ansatzbildung ist. Zudem hat die DE 10 2008 043 412 A1 ein Füllstandsmessgerät mit einer Speichereinheit zum Gegenstand, auf welcher Grenzwerte für unterschiedliche Medien abgelegt sind. Bei Über- oder Unterschreiten eines solchen Grenzwertes wird ein Schaltsignal erzeugt derart, dass eine Ansatzbildung das zuverlässige Schalten nicht beeinflusst.

Um eine Prozessgröße, insbesondere einen vorgegebenen Füllstand, eines Mediums mit einem einzigen Messgerät unabhängig von den elektrischen Eigenschaften des Mediums erfassen zu können, ist aus der DE102011004807A1 eine Sondeneinheit mit zumindest abschnittsweise koaxialem Aufbau für eine Vorrichtung zur kapazitiven oder konduktiven Bestimmung zumindest einer Prozessgröße eines Mediums in einem Behälter bekannt geworden. Diese Sondeneinheit kann im Wesentlichen frontbündig in einen Behälter eingebaut werden, was insbesondere in Bezug auf hygienische Standards, welche für bestimmte Anwendungen eingehalten werden müssen, von Vorteil ist.

Ein derartiger Multisensor ist auch Gegenstand der DE102013102055A1, welche ein Verfahren und eine Vorrichtung beschreibt, mittels welchem/welcher ein vorgegebener Füllstand abwechselnd in einem konduktiven und einem kapazitiven Betriebsmodus bestimmt werden kann. Um weiterhin eine verbesserte Messauflösung erzielen zu können, ist aus der DE102014107927A1 bekannt geworden, eine Messsonde mit einem aus zwei periodischen Teilsignalen zusammengesetzten Erregersignal zu beaufschlagen, wobei ein erstes Teilsignal für einen kapazitiven Betriebsmodus generiert wird und ein zweites Teilsignal für einen konduktiven Betriebsmodus.

In der DE102013104781A1 sind schließlich ein Verfahren und eine Vorrichtung offenbart, die die Überwachung zumindest einer medienspezifischen Eigenschaft eines Mediums in einem kapazitiven und konduktiven Betriebsmodus erlauben. Dabei kann es um die elektrische Leitfähigkeit des Mediums, oder auch um eine dielektrische Eigenschaft des Mediums, wie beispielsweise dessen Dielektrizitätszahl, handeln.

In der Veröffentlichungsschrift DE 10 2013 111188 A1 wird ein Verfahren zur Bestimmung einer Durchmischung zweier Medien in einem Extruder mit Entgasungsdom beschrieben. Das dortige Verfahren basiert auf kapazitiver und konduktiver Messung, wobei die Leitfähigkeit bzw. die Dielektrizitätskonstante der Medien bestimmt wird.

Ausgehend von dem genannten Stand der Technik liegt der vorliegenden Erfindung die Aufgabe zugrunde, den Einsatzbereich einer kapazitiven und konduktiven Messsonde zu erweitern.

Diese Aufgabe wird gelöst durch das Verfahren gemäß Anspruch 1 und durch die Vorrichtung gemäß Anspruch 3.

Bezüglich des Verfahren wird die der Erfindung zugrunde liegende Aufgabe gelöst durch ein Verfahren zur Überwachung einer Durchmischung von zumindest einem ersten Medium und einem zweiten Medium in einem Behälter der Automatisierungstechnik anhand einer Messsonde,
umfassend folgende Verfahrensschritte:
- Einfüllen des Mediums in den Behälter,
- Ermitteln der elektrischen Leitfähigkeit in einem konduktiven Betriebsmodus der Messsonde und der Dielektrizitätskonstanten in einem kapazitiven Betriebsmodus der Messsonde,
- Aufzeichnen des zeitlichen Verlaufs der elektrischen Leitfähigkeit und der Dielektrizitätskonstanten,
- Ermitteln, ob die Messsonde zumindest teilweise mit dem ersten Medium in Kontakt ist,
- wobei überprüft wird, ob ein vorgebbarer Füllstand des ersten Mediums in dem Behälter erreicht ist, wobei anschließend das zweite Medium in den Behälter eingefüllt wird und die Überwachung der Durchmischung ausgeführt wird, und
- Überwachung zumindest der innerhalb des Behälters ablaufenden Durchmischung der Medien anhand des zeitlichen Verlaufs der elektrischen Leitfähigkeit und der Dielektrizitätskonstanten.

Hinsichtlich des kapazitiven bzw. konduktiven Betriebsmodus sei insbesondere auf die DE102013104781A1 verwiesen, auf deren Offenbarungsgehalt hiermit vollumfänglich Bezug genommen wird.

In einer weiteren Ausgestaltung des Verfahrens wird zumindest ein Prozessparameter, insbesondere die Temperatur oder der Druck des zumindest einen Mediums in dem Behälter, ermittelt und zur Überwachung des Prozesses herangezogen.

Bei dem vorgebbaren Füllstand handelt es sich beispielsweise um einen Füllstand, welcher einer vorgebbaren Bedeckung der Messsonde durch das Medium, vorzugsweise einer vollständigen Bedeckung der Messsonde durch das Medium, entspricht. In einer alternativen Ausgestaltung des Verfahrens wird ermittelt, ob die Messsonde zumindest teilweise, vorzugsweise vollständig durch einen dünnen Film des zumindest einen Mediums bedeckt ist. Es wird also beispielsweise ermittelt, ob ein Rückstand des Mediums im Bereich der Messsonde vorhanden ist.

Die erfindungsgemäße Aufgabe wird außerdem gelöst durch eine Vorrichtung zur Prozessüberwachung in der Automatisierungstechnik umfassend eine kapazitive und konduktive Messsonde und eine Elektronikeinheit, welche dazu ausgestaltet ist, zumindest eine Ausgestaltung des erfindungsgemäßen Verfahrens auszuführen. Die Vorrichtung ist beispielsweise entsprechend der DE102011004807A1 ausgestaltet und weist eine Messsonde mit zumindest abschnittsweise koaxialem Aufbau auf. Diese Sondeneinheit kann beispielsweise derart ausgestaltet sein, dass sie im Wesentlichen frontbündig in einen Behälter eingebaut werden kann. Neben der DE102011004807A1 sei in dieser Hinsicht ebenfalls auf die DE102014107927A1 verwiesen. Auf beide Dokumente wird hiermit Bezug genommen.

Bezüglich der Vorrichtung ist es von Vorteil, wenn diese eine, insbesondere digitale, Schnittstelle, zur Übertragung der ermittelten Messwerte zumindest der elektrischen Leitfähigkeit, der Dielektrizitätskonstante und/oder des Bedeckungsgrades an eine externe Einheit, umfasst.

Ebenso ist es von Vorteil, wenn die Vorrichtung eine Anzeigeeinheit zur Anzeige zeitlichen Verlaufs zumindest der elektrischen Leitfähigkeit, der Dielektrizitätskonstante und/oder des Bedeckungsgrades, und/oder zur Anzeige einer Aussage über den innerhalb des Behälters ablaufenden Prozess, umfasst.

Es sei darauf verwiesen, dass die in Zusammenhang mit dem erfindungsgemäßen Verfahren beschriebenen Ausgestaltungen mutatis mutandis auch auf die erfindungsgemäße Vorrichtung anwendbar sind und umgekehrt.

Die Erfindung wird anhand der nachfolgenden Figuren näher erläutert. Es zeigt:
Fig. 1 zeigt eine schematische Darstellung einer kapazitiven und/oder konduktiven Messsonde gemäß Stand der Technik,
Fig. 2: eine schematische Darstellung zur Überwachung der Durchmischung zweier Medium mittels einer Ausgestaltung des erfindungsgemäßen Verfahrens, und
Fig. 3: eine schematische Darstellung zur Überwachung eines Reinigungsprozesses in einem Behälter.

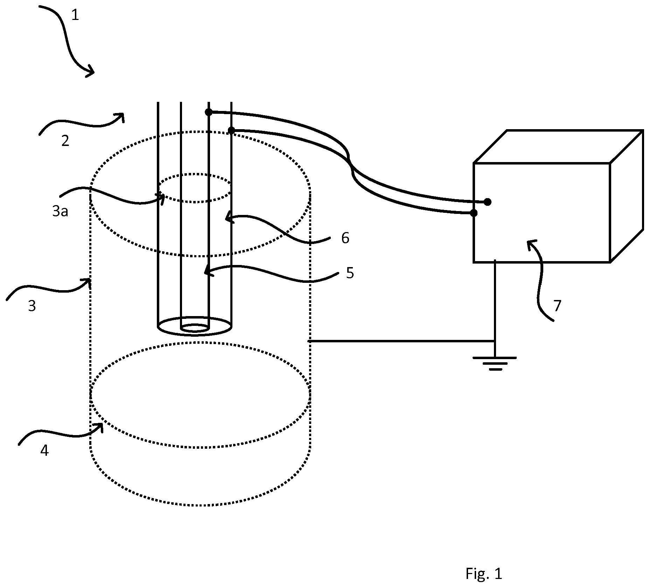

In Fig. 1 ist Messgerät 1 gemäß Stand der Technik gezeigt, mittels welchem eine Prozessgröße, wie beispielsweise ein Füllstand oder ein vorgegebener Füllstand, im kapazitiven und/oder konduktiven Messverfahren, bestimmt und/oder überwacht werden kann. Eine Messsonde 2 ist in einen Behälter 3 eingebracht, welcher zumindest teilweise mit einem Medium 4 gefüllt ist. In diesem Fall ist sie über eine Öffnung 3a in der Oberseite des Behälters 3 in diesen eingebracht. Im hier gezeigten Beispiel ragt die Messsonde 2 von oben in den Behälter 3 hinein. Alternativ kann die Messsonde 2 auch von einer Seitenwand des Behälters 3 ausgehend in diesen eingebracht sein. Es versteht sich ferner von selbst, dass auch frontbündige Messsonden möglich sind, welche im Wesentlichen mit der Bewandung des Behälters 3 abschließen, was insbesondere im Falle von Rohren oder Behältern mit kleinen von Vorteil sein kann. Eine solche Messsonde wird beispielsweise von der Anmelderin unter Bezeichnung FTW33 hergestellt und vertrieben.

Die Messsonde 2 im hier gezeigten Beispiel setzt sich aus einer Sensorelektrode 5 und einer Guardelektrode 6 zusammen. Beide Elektroden sind elektrisch mit einer Elektronikeinheit 7 verbunden, welche zur Signalerfassung, -auswertung und/oder - speisung verantwortlich ist. Eine Masseelektrode wird im Beispiel gemäß Fig. 1 durch die Wandung des Behälters 3 dargestellt. Der Behälter 3 besteht im vorliegenden Fall entsprechend aus einem elektrisch leitfähigen Material. Selbstverständlich kann eine Masseelektrode alternativ aber bei Behältern 3 mit einer Wandung aus einem nicht leitfähigen Material als integrale Komponente der Messsonde 2, oder als weitere separate Elektrode ausgebildet sein.

Die Elektronikeinheit 7 bestimmt und/oder überwacht in einem Messbetriebsmodus anhand der im kapazitiven und konduktiven Betriebsmodus erzeugten Antwortsignale eine Prozessgröße, wie beispielsweise, ob ein vorgegebener Füllstand des Mediums 4 in dem Behälter 3 über und/oder unterschritten ist, und generiert ggf. im Falle des Erreichens eines vorgegebenen Füllstands eine entsprechende Meldung, bzw. löst einen entsprechenden Schaltvorgang aus. Hierzu kann die Elektronikeinheit 7 aus zwei Teileinheiten für die beiden Betriebsmodi zusammengesetzt sein, wie beispielsweise in der DE102013104781A1 beschrieben, oder in Form einer einzelnen Elektronikeinheit 7, welche für beide Betriebsmodi einsetzbar ist, wie wiederum beispielsweise in der DE102014107927A1 vorgeschlagen.

Zur Prozessüberwachung gemäß einem erfindungsgemäßen Verfahren wird zuerst ermittelt, ob die Messsonde 2 zumindest teilweise mit dem Medium 4 in Kontakt ist. Beispielsweise kann überprüft werden, ob die Messsonde 2 im Wesentlichen vollständig vom Medium 4 bedeckt ist. Dies ist beispielsweise von Vorteil, wenn eine Durchmischung von zumindest zwei unterschiedlichen Medien 4 überwacht wird. Alternativ ist es ebenfalls möglich, zu überprüfen, ob die Messsonde 2 zumindest teilweise von einem dünnen Film aus dem Medium 4 bedeckt ist. Vorzugsweise ist in diesem Falle die Messsonde zumindest zu etwa 50% von dem Medium 4 bedeckt.

Zur Durchführung des erfindungsgemäßen Verfahrens wird dann der zeitliche Verlauf zumindest einer elektrischen Leitfähigkeit des zumindest einen Mediums 4, einer Dielektrizitätskonstanten des zumindest einen Mediums 4 und/oder eines Bedeckungsgrades der Messsonde 2 durch das Medium 4 aufgezeichnet und anhand dieses Verlaufs der jeweils zu überwachende, innerhalb des Behälters 3 ablaufende Prozess überwacht.

Bezüglich der Ermittlung der elektrischen Leitfähigkeit oder der Dielektrizitätskonstanten des Mediums 4 sei auf die DE102014107927A1 verwiesen. Der Bedeckungsgrad B ist wiederum definiert als das Verhältnis eines von der Sensorelektrode 5 abgreifbaren Sensorstroms und eines an der Guardelektrode 6 abgreifbaren Guardstroms.

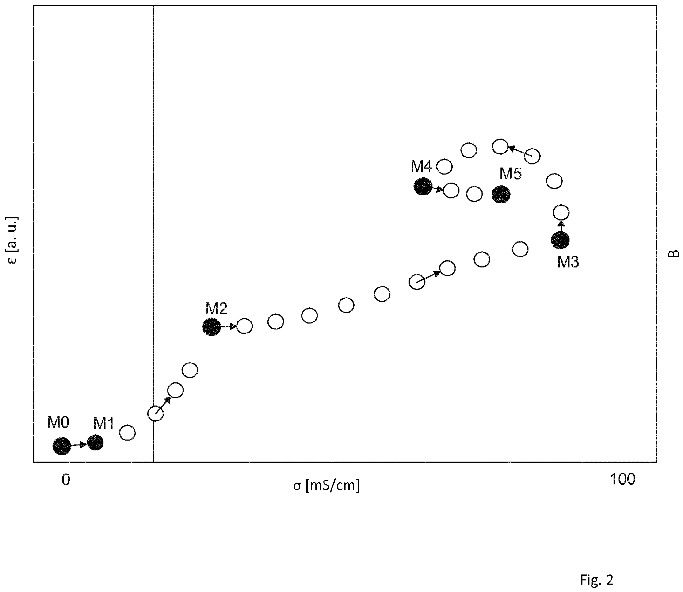

Eine Ausgestaltung des erfindungsgemäßen Verfahrens ist in Fig. 2 illustriert. Be dem zu überwachenden Prozess handelt es sich um einen Mischvorgang eines ersten 4a und eines zweiten Mediums 4b in einem Behälter 3. Die Abbildung zeigt eine grafische Darstellung des Bedeckungsgrades B, der elektrischen Leitfähigkeit σ bzw. der Dielektrizitätszahl ε als Funktion der Zeit t. Mittels eines geeigneten Anzeigeelements [nicht gezeigt] kann eine derartige Darstellung direkt am Messgerät 1 sichtbar gemacht werden. Bei der Anzeigeeinheit kann es sich beispielsweise um einen grafischen Schleppzeiger bzw. Logger handeln. In diesem Falle ist das Messgerät 1 direkt dazu ausgestaltet, zumindest eine Ausgestaltung des erfindungsgemäßen Verfahrens durchzuführen. Beispielsweise kann die Elektronikeinheit 7 über geeignete Mittel, wie zum Beispiel eine Recheneinheit und/oder eine Speichereinheit, verfügen.

Alternativ kann das Messgerät 1 auch über eine, insbesondere digitale, Kommunikationsschnittstelle [ebenfalls nicht gezeigt], beispielsweise eine I/O Link Schnittstelle, verfügen. Sowohl drahtgebundene als auch drahtlose Schnittstellen sind in diesem Zusammenhang möglich. Es ist beispielsweise denkbar, dass das jeweilige Verfahren in einer externen Einheit [nicht gezeigt], beispielsweise einem Computer durchgeführt sein. Hierzu kann das Verfahren beispielsweise in Form eines Computerprogramms implementiert sein. Alternativ kann das Verfahren auch auf einem computerlesbaren Medium implementiert sein.

Zum Zeitpunkt M0 ist die Messsonde 2 an Luft. Zum Zeitpunkt M1 wird ein Füllvorgang des Behälters 3 mit einem ersten Medium 4a gestartet. Zum Zeitpunkt M2 wird ein vorgebbarer Füllstand des ersten Mediums 4a im Behälter 3 erreicht. Der vorgebbare Füllstand entspricht im vorliegenden Beispiel einer im Wesentlichen vollständigen Bedeckung der Messsonde 2 mit dem ersten Medium 4a. Zum Zeitpunkt M2 wird ein zweites Medium 4b in den Behälter eingefüllt und ein Mischvorgang der beiden Medien 4a und 4b gestartet. Sobald zum Zeitpunkt M3 eine vollständige und im Wesentlichen homogene Durchmischung der beiden Medien 4a und 4b erreicht ist, bleibt der jeweils aufgezeichnete Messwert konstant. Im gezeigten Beispiel in Fig. 2 wird zum Zeitpunkt M3 ferner ein Heizvorgang der beiden durchmischten Medien 4a und 4b gestartet und der Behälter 3 vakuumisiert. In diesem Zeitraum zwischen den Zeitpunkten M3 und M4 ändern sich die elektrische Leitfähigkeit σ und die Konsistenz der Medien 4a und 4b im Behälter 3 kontinuierlich. Zum Zeitpunkt M4 wird ein drittes Medium 4c in den Behälter 3 zugegeben und erneut ein Mischvorgang innerhalb des Behälters 3 gestartet. Wieder kann die Homogenität der Durchmischung beispielsweise anhand einer konstant bleibenden elektrischen Leitfähigkeit σ nachgewiesen werden. Dies ist im vorliegenden Beispiel zum Zeitpunkt M5 der Fall.

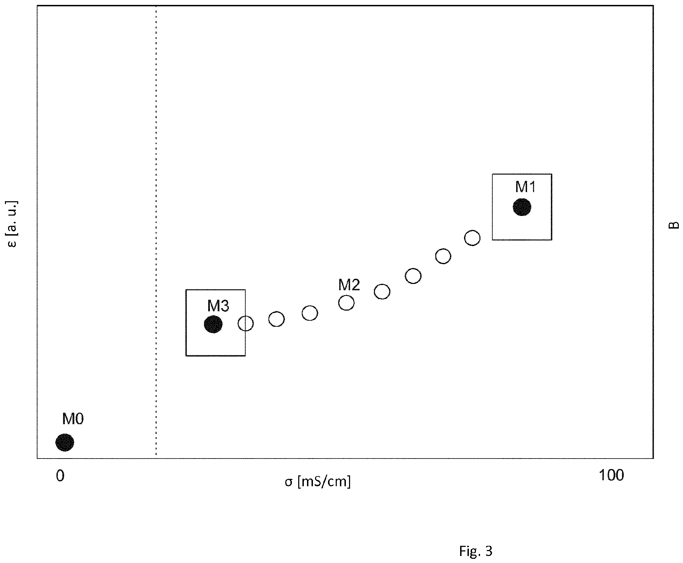

Ein nicht erfindungsgemäßes Verfahren ist in Fig. 3 gezeigt. Hierbei handelt es sich um einen in dem Behälter ablaufenden Reinigungsprozess. Zur Reinigung des Behälters wird üblicherweise der Behälter 3 zumindest teilweise mit einer geeigneten Reinigungsflüssigkeit gefüllt. Üblicherweise umfasst ein Reinigungsprozess mehrere Zyklen, in denen jeweils eine oder mehrere Reinigungsflüssigkeiten in den Behälter 3 eingebracht werden. Zum Zeitpunkt M1 hat der Reinigungsprozess noch nicht begonnen. Im hier gezeigten Beispiel sinkt die elektrische Leitfähigkeit σ proportional zum Fortschritt der Reinigung. Zum Zeitpunkt M2 wird ein zweiter Zyklus des Reinigungsprozesses gestartet. Sobald zum Zeitpunkt M3 detektiert wird, dass die elektrische Leitfähigkeit für eine vorgebbaren Zeitdauer im Wesentlichen konstant ist, kann der Reinigungsprozess beendet werden. Ein Fortschritt des Reinigungsprozesses kann also anhand einer Änderung der elektrischen Leitfähigkeit σ, der Dielektrizitätskonstanten ε und/oder des Bedeckungsgrades B überwacht werden. Ebenso kann anhand zumindest einer dieser Größen überwacht werden, ob nach Abschluss eines Reinigungszyklus Rückstände des Mediums 4 in dem Behälter 3 verblieben sind. In diesem Falle hat beispielsweise die elektrische Leitfähigkeit σ des Mediums 4 bzw. der Reinigungsflüssigkeit 4, noch kein Plateau erreicht.

Ein Reinigungsprozess kann dabei sowohl dann zuverlässig überwacht werden, wenn die Messsonde 2 während der einzelnen Zyklen im Wesentlichen vollständig von der Reinigungsflüssigkeit, welche für die Überwachung eines Reinigungsprozesses dem jeweiligen Medium 4 entspricht, bedeckt ist, als auch in dem Fall, dass die Messsonde 2 von einem dünnen Film der Reinigungsflüssigkeit 4 bedeckt ist. Dies entspricht einem dünnen Sprühfilm auf der Messsonde 2.

Anhand des zeitlichen Verlaufs der gemessenen elektrischen Leitfähigkeit σ, der Dielektrizitätskonstanten ε und/oder des Bedeckungsgrades B lassen sich also qualitative Informationen über verschiedene Prozesse in der Automatisierungstechnik erhalten. Es sei darauf verwiesen, dass zur Prozessüberwachung nicht, wie im in Fig. 2 gezeigten Beispiel notwendigerweise die elektrischen Leitfähigkeit σ, die Dielektrizitätskonstanten ε und der Bedeckungsgrad simultan als Funktion der Zeit betrachtet werden müssen. Vielmehr kann es für die gewünschte Prozessüberwachung ebenfalls ausreichend sein, wenn nur eine oder zwei der genannten Größen gemessenen wird. Es sei darauf verwiesen, dass neben den beiden genannten Beispielen für einzelne Prozessüberwachungen auch zahlreiche andere Prozesse überwacht werden können, welche allesamt unter die vorliegende Erfindung fallen. Beispielsweise sei in diesem Zusammenhang darauf verwiesen, dass das Vorliegen eines vorgebbaren Mengenverhältnisses zumindest eines ersten 4a und eines zweiten Mediums 4b in dem Behälter 3, oder auch die Einhaltung einer Rezeptur überwacht werden können.

Beispielsweise können für die elektrische Leitfähigkeit σ, die Dielektrizitätskonstante ε und/oder den Bedeckungsgrad B jeweils Referenzwerte oder Referenzkurven aufgenommen und hinterlegt werden. Diese Referenzwerte oder Referenzkurven entsprechen dann einem korrekt ablaufenden Prozess. In vorgebbaren Zeitintervallen, oder während der Durchführung des jeweils zu überwachenden Prozesses können dann entsprechend gemessene Werte oder Kurven für die elektrischen Leitfähigkeit σ, die Dielektrizitätskonstante ε und/oder den Bedeckungsgrad B aufgezeichnet und mit den Referenzwerten oder Referenzkurven verglichen werden. Wenn eine Abweichung zwischen den jeweils gemessenen Werten oder Kurven und den jeweils zugehörigen Referenzwerten oder Referenzkurven einen vorgebbaren Grenzwert überschreitet, kann dann beispielsweise auf einen Fehler in dem jeweiligen Prozess rückgeschlossen und ggf. eine Meldung generiert und ausgegeben werden.

### Bezugszeichenliste

- 1: Messgerät
- 2: Messsonde
- 3: Behälter
- 3a: Öffnung im Behälter
- 4: Medium
- 4a-4c: erstes, zweites, drittes Medium
- 5: Sensorelektrode
- 6: Guardelektrode
- 7: Elektronikeinheit

- M0-M5: Zeitpunkte während des jeweils zu überwachenden Prozesses
- σ: elektrische Leitfähigkeit
- ε: Dielektrizitätskonstante

## Patentansprüche

1. Verfahren zur Überwachung einer Durchmischung von zumindest einem ersten Medium (4a) und einem zweiten Medium (4b) in einem Behälter (3) der Automatisierungstechnik anhand einer Messsonde (2),
umfassend folgende Verfahrensschritte:
- Einfüllen des Mediums (4a) in den Behälter (3),
- Ermitteln der elektrischen Leitfähigkeit (σ) in einem konduktiven Betriebsmodus der Messsonde (2) und der Dielektrizitätskonstanten (ε) in einem kapazitiven Betriebsmodus der Messsonde (2),
- Aufzeichnen des zeitlichen Verlaufs der elektrischen Leitfähigkeit (σ) und der Dielektrizitätskonstanten (ε),
- Ermitteln, ob die Messsonde (2) zumindest teilweise mit dem ersten Medium (4a) in Kontakt ist,
- wobei überprüft wird, ob ein vorgebbarer Füllstand des ersten Mediums (4a) in dem Behälter (3) erreicht ist, wobei anschließend das zweite Medium in den Behälter eingefüllt wird und die Überwachung der Durchmischung ausgeführt wird, und
- Überwachung zumindest der innerhalb des Behälters (3) ablaufenden Durchmischung der Medien (4a, 4b) anhand des zeitlichen Verlaufs der elektrischen Leitfähigkeit (σ) und der Dielektrizitätskonstanten (ε).

2. Verfahren nach Anspruch 1,
wobei zumindest ein Prozessparameter, insbesondere die Temperatur oder der Druck des zumindest einen Mediums (4a, b) in dem Behälter (3), ermittelt und zur Überwachung der Durchmischung herangezogen wird.

3. Vorrichtung (1) zur Prozessüberwachung in der Automatisierungstechnik umfassend eine kapazitive und konduktive Messsonde (2) und eine Elektronikeinheit (7), welche dazu ausgestaltet ist, ein Verfahren nach einem der vorhergehenden Ansprüche auszuführen.

4. Vorrichtung nach Anspruch 3,
umfassend eine, insbesondere digitale, Schnittstelle, zur Übertragung der ermittelten Messwerte zumindest der elektrischen Leitfähigkeit (σ), der Dielektrizitätskonstanten (ε) und/oder des Bedeckungsgrades (B) an eine externe Einheit.

5. Vorrichtung nach Anspruch 3 oder 4,
umfassend eine Anzeigeeinheit zur Anzeige zeitlichen Verlaufs zumindest der elektrischen Leitfähigkeit (σ), der Dielektrizitätskonstanten (ε) und/oder des Bedeckungsgrades (B), und/oder zur Anzeige einer Aussage über den innerhalb des Behälters (4) ablaufenden Prozess.

## Claims

1. A method for monitoring a mixing of at least a first medium (4a) and a second medium (4b) in a container (3) from automation technology based on a measurement probe (2),
the method comprising the following method steps:
filling the medium (4a) into the container (3),
determining the electrical conductivity (σ) in a conductive operating mode of the measurement probe (2) and of the dielectric constant (ε) in a capacitive operating mode of the measurement probe (2),
recording the temporal progression of the electrical conductivity (σ) and of the dielectric constant (ε),
determining whether the measurement probe (2) is at least partially in contact with the first medium (4a),
wherein it is checked whether a predefinable fill level of the first medium (4a) in the container (3) is reached, wherein the second medium is then filled into the container and the monitoring of the mixing is performed, and
monitoring at least the mixing of the media (4a, 4b), taking place inside the container (3), based on the temporal progression of the electrical conductivity (σ) and the dielectric constant (ε).

2. The method as claimed in claim 1,
wherein at least one process parameter, in particular the temperature or the pressure of the at least one medium (4a, b) in the container (3), is determined and is used to monitor the mixing.

3. An apparatus (1) for process monitoring in automation technology comprising a capacitive and conductive measurement probe (2) and an electronic unit (7), which is designed to carry out at least one method as claimed in one of the preceding claims.

4. The apparatus as claimed in claim 3,
comprising an interface, in particular a digital interface, for transmitting the determined measured values of at least the electrical conductivity (σ), the dielectric constant (ε) and/or the degree of coverage (B) to an external unit.

5. The apparatus as claimed in claim 3 or 4,
comprising a display unit for displaying the temporal progression of at least the electrical conductivity (σ), the dielectric constant (ε) and/or the degree of coverage (B), and/or for displaying a statement regarding the process taking place inside the container (4).

## Revendications

1. Procédé destiné à la surveillance d'un mélange d'au moins un premier produit (4a) et d'un deuxième produit (4b) se trouvant dans un réservoir (3) de la technique d'automatisation à l'aide d'une sonde de mesure (2), lequel procédé comprend les étapes suivantes :
- Remplissage du produit (4a) dans le récipient (3),
- Détermination de la conductivité électrique (σ) dans un mode de fonctionnement conductif de la sonde de mesure (2) et de la constante diélectrique (ε) dans un mode de fonctionnement capacitif de la sonde de mesure (2),
- Enregistrement de l'évolution dans le temps de la conductivité électrique (σ) et de la constante diélectrique (ε),
- Détermination si la sonde de mesure (2) est au moins partiellement en contact avec le premier produit (4a),
- Une vérification ayant lieu pour vérifier si un niveau prédéfinissable du premier produit (4a) est atteint dans le réservoir (3), le deuxième produit étant ensuite versé dans le réservoir et la surveillance du mélange étant effectuée, et
- Surveillance au moins du mélange des produits (4a, 4b) se déroulant à l'intérieur du réservoir (3) à l'aide de l'évolution dans le temps de la conductivité électrique (σ) et des constantes diélectriques (ε).

2. Procédé selon la revendication 1,
pour lequel au moins un paramètre de process, notamment la température ou la pression de l'au moins un produit (4a, b) se trouvant dans le réservoir (3), est déterminé et utilisé pour surveiller le mélange.

3. Dispositif (1) destiné à la surveillance de process dans la technique
d'automatisation, lequel dispositif comprend une sonde de mesure capacitive et conductive (2) ainsi qu'une unité électronique (7), laquelle unité est conçue pour exécuter un procédé selon l'une des revendications précédentes.

4. Dispositif (1) selon la revendication 3,
lequel dispositif comprend une interface, notamment numérique, pour la transmission à une unité externe des valeurs de mesure déterminées au moins de la conductivité électrique (σ), de la constante diélectrique (ε) et/ou du degré de couverture (B).

5. Dispositif (1) selon la revendication 3 ou 4,
lequel dispositif comprend une unité d'affichage pour l'affichage de l'évolution dans le temps au moins de la conductivité électrique (σ), de la constante diélectrique (ε) et/ou du degré de couverture (B), et/ou pour l'affichage d'une information sur le process qui se déroule à l'intérieur du réservoir (4).
